# FASCICULE DE BREVET EUROPEEN

(11) **EP 4 354 476 B1**
(45) Date de publication et mention de la délivrance du brevet: **25.11.2026**
(21) Numéro de dépôt: 23201024.9
(22) Date de dépôt: 29.09.2023
(51) Int. Cl.: H01G 4/30, H01G 4/33, H01G 4/005, H01G 4/012, H01G 4/12, H01G 4/232, H01G 4/10, H01G 4/20

(54) **PROCEDE DE FABRICATION D'UN CONDENSATEUR**
VERFAHREN ZUR HERSTELLUNG EINES KONDENSATORS
METHOD FOR MANUFACTURING CAPACITOR

(30) Priorité: 14.10.2022 FR 2210596
(43) Date de publication de la demande: 17.04.2024
(73) Titulaire: STMicroelectronics (Tours) SAS, 37100 Tours (FR)
(72) Inventeur: BOUFNICHEL, Mohamed, 37380 MONNAIE (FR)
(74) Mandataire: Cabinet Beaumont

(56) Documents cités:
- JP-A- 2010 153 855
- KR-A- 20060 114 056
- KR-B1- 100 866 683
- US-A1- 2003 129 771
- US-A1- 2011 108 951
- US-A1- 2020 006 470

## Description

### Domaine technique

La présente description concerne de façon générale la fabrication d'un circuit intégré et vise plus particulièrement la fabrication d'un circuit intégré comportant un condensateur, par exemple un filtre RC (comportant une résistance et un condensateur), un filtre LC (comportant une inductance et un condensateur) ou un filtre RLC (comportant une résistance, une inductance et un condensateur) .

### Technique antérieure

De nombreux procédés de fabrication de circuits intégrés comportant des condensateurs ont été proposés. Ces procédés présentent divers inconvénients. Il existe alors un besoin d'amélioration des procédés de fabrication d'un circuit intégré comprenant un condensateur pour pallier tout ou partie des inconvénients des procédés connus.

### Résumé de l'invention

La présente invention concerne un procédé de fabrication d'un condensateur selon la revendication 1 et un condensateur selon la revendication 12. D'autres modes de réalisation sont définis dans les revendications dépendantes. Un aspect de l'invention prévoit un procédé de fabrication d'un condensateur, comportant les étapes successives suivantes :
a) former un empilement comportant une face inférieure et une face supérieure, l'empilement comportant, dans l'ordre à partir de sa face inférieure, une première couche conductrice, une première électrode, une première couche diélectrique, une deuxième électrode et une deuxième couche conductrice ;
b) graver, par gravure localisée, à partir de la face supérieure de l'empilement, la deuxième couche conductrice, la deuxième électrode et une partie de l'épaisseur de la première couche diélectrique dans une partie périphérique de l'empilement ;
c) déposer une deuxième couche diélectrique, de façon conforme, sur toute la surface supérieure et les flancs d'une partie centrale, non gravée à l'étape b), de l'empilement, et sur la partie périphérique de l'empilement ; et
d) graver la deuxième couche diélectrique, la première couche diélectrique et la première électrode, par gravure anisotrope verticale non localisée, jusqu'à exposer la face supérieure de la deuxième couche conductrice dans ladite partie centrale, non gravée à l'étape b), de l'empilement et la face supérieure de la première couche conductrice dans la partie périphérique de l'empilement, et en laissant subsister une portion de la deuxième couche diélectrique sur les flancs de ladite partie centrale de l'empilement.

Selon l'invention, à l'issue de l'étape d), une portion de la deuxième couche diélectrique subsiste sur le flanc de la partie centrale de l'empilement.

Selon un mode de réalisation, la gravure à l'étape b) est une gravure par plasma chimique.

Selon un mode de réalisation, le plasma de la gravure à l'étape b) est à base de chlore.

Selon un mode de réalisation, la gravure de l'étape d) est effectuée pleine plaque.

Selon un mode de réalisation, la gravure à l'étape d) est une gravure par plasma chimique.

Selon un mode de réalisation, le plasma de la gravure à l'étape b) est à base de fluor.

Selon l'invention, lors de l'étape c), la deuxième couche diélectrique est formée de façon conforme.

Selon un mode de réalisation, le procédé comporte, entre les étapes a) et b), une étape de formation d'un masque de gravure.

Selon un mode de réalisation, les première et deuxième couches conductrices sont à base d'aluminium.

Selon un mode de réalisation, les première et deuxième couches diélectriques, sont en le même matériau.

Selon un mode de réalisation, les première et deuxième couches diélectriques sont en nitrure de silicium.

Selon un mode de réalisation, les première et deuxième électrodes sont en nitrure de tantale.

Un autre aspect de l'invention prévoit un condensateur comportant une première couche conductrice sur laquelle est formé un empilement, comportant, à partir de la face supérieure de la première couche, une première électrode, une première couche diélectrique, une deuxième électrode et une deuxième couche conductrice, l'empilement comportant une marche, dans la deuxième couche conductrice, la deuxième électrode et dans une partie de l'épaisseur de la première couche diélectrique, la marche étant comblée par une deuxième couche diélectrique de sorte que les flancs de la première électrode soient alignés avec les flancs de la deuxième couche diélectrique.

Selon un mode de réalisation, le condensateur est formé à partir du procédé décrit ci-avant.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe illustrant une étape d'un procédé de fabrication d'un condensateur selon un mode de réalisation ;
la figure 2 est une vue en coupe illustrant une autre étape d'un procédé de fabrication d'un condensateur selon un mode de réalisation ;
la figure 3 est une vue en coupe illustrant une autre étape d'un procédé de fabrication d'un condensateur selon un mode de réalisation ;
la figure 4 est une vue en coupe illustrant une autre étape d'un procédé de fabrication d'un condensateur selon un mode de réalisation ; et
la figure 5 est une vue en coupe illustrant une autre étape d'un procédé de fabrication d'un condensateur selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, on s'intéresse ici principalement à la formation d'une portion de circuit intégré formant le condensateur. Les autres étapes du procédé de fabrication du circuit intégré sont à la portée de la personne du métier et ne seront pas décrites ci-après.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

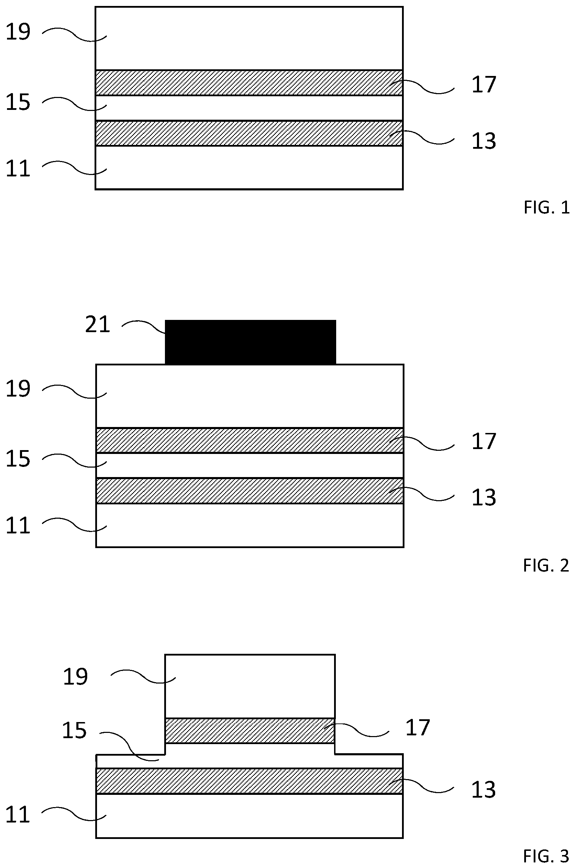

Les figures 1 à 5 sont des vues en coupe illustrant des étapes successives d'un exemple d'un procédé de fabrication d'un condensateur selon un mode de réalisation.

La figure 1 représente un empilement de départ comportant, successivement, à partir d'une face inférieure de l'empilement, une première couche conductrice 11, une première électrode 13, une première couche diélectrique 15, une deuxième électrode 17, et une deuxième couche conductrice 19.

A titre d'exemple, l'empilement est porté par un support non représenté. Le support permet, par exemple, de porter d'autres éléments tels que des inductances ou des résistances formées à proximité du condensateur. Le support est, par exemple un substrat en verre ou en silicium, de préférence fortement résistif. Le support est, par exemple séparé de la couche conductrice 11 par une couche diélectrique, par exemple une couche d'oxyde, par exemple du verre de silicium non dopé ou tout autre oxyde de silicium.

La première couche conductrice 11, aussi appelée couche de redistribution ou RDL (de l'anglais "redistribution layer") est, par exemple, en un matériau métallique. A titre d'exemple, la couche conductrice 11 est en aluminium ou en un alliage à base d'aluminium. La couche conductrice 11 est, par exemple, en un alliage d'aluminium et de cuivre (AlCu) ou en un alliage d'aluminium, de cuivre et de silicium (AlSiCu). A titre d'exemple, la couche conductrice 11 a une épaisseur comprise entre 0,5 µm et 3 µm, par exemple de l'ordre de 1,5 µm.

La première électrode 13 est, par exemple, située sur et en contact avec la couche conductrice 11. Les électrodes 13 et 17 peuvent être en un même matériau ou en des matériaux différents. Les électrodes 13 et 17 peuvent, par exemple, être en nitrure de tantale (TaN). A titre de variante, les électrodes 13 et 17 peuvent être en silicium polycristallin ou en platine. A titre d'exemple, l'électrode 13 a une épaisseur comprise entre 20 nm et 200 nm, de préférence de l'ordre d'environ 80 nm. A titre d'exemple, l'électrode 17 a une épaisseur comprise entre 20 nm et 200 nm, de préférence de l'ordre d'environ 80 nm. A titre d'exemple, l'électrode 13 a une épaisseur égale à l'épaisseur de l'électrode 17.

Les électrodes 13 et 17, aussi appelées respectivement électrodes inférieure et supérieure, sont séparées par la couche diélectrique 15. A titre d'exemple, la couche diélectrique 15 est située sur et en contact avec l'électrode 13 et l'électrode 17 est située sur et en contact avec la couche diélectrique 15. La couche 15 est en un matériau diélectrique. A titre d'exemple, la couche diélectrique 15 est en nitrure de silicium (Si₃N₄) ou en oxyde nitrure de tantale (TaON). La couche diélectrique 15 a, par exemple une épaisseur comprise entre 20 nm et 600 nm, par exemple de l'ordre de 100 nm, de l'ordre de 175 nm ou de l'ordre de 400 nm.

L'électrode 17 est surmontée de la couche conductrice 19. A titre d'exemple, la couche conductrice 19 est située sur et en contact avec l'électrode 17. A titre d'exemple, la couche conductrice 19 est en un matériau métallique. Plus précisément, la couche conductrice 19 est un matériau métallique pouvant être gravé par plasma. A titre d'exemple, la couche conductrice 19 est en aluminium, en cuivre, en platine, en tungstène, en titane ou en un alliage à base de l'un de ces matériaux comme en un alliage de cuivre-titane (TiCu), un alliage de cuivre-aluminium (AlCu) ou un alliage de titane-tungstène (TiW). A titre d'exemple, la couche 19 a une épaisseur comprise entre 20 nm et 600 nm, par exemple de l'ordre de 400 nm.

Dans l'empilement illustré en figure 1, les couches et électrodes 13, 15, 17 et 19 sont alignées verticalement. En particulier, elles s'étendent chacune au dessus de toute la surface supérieure de la couche conductrice 11.

La figure 2 illustre une structure obtenue à l'issue d'une étape de dépôt d'une couche de masquage 21 sur la face avant de l'empilement illustré en figure 1.

Lors de cette étape, on vient déposer la couche de masquage 21, par exemple par centrifugation, sur la face supérieure de la structure, c'est-à-dire la face avant de la structure dans l'orientation de la figure 2. Plus précisément, on vient déposer la couche de masquage 21 sur et en contact avec la face supérieure de la couche conductrice 19.

A l'issue de l'étape de dépôt de la couche de masquage 21, celle-ci est retirée localement, par exemple par photolithographie. A titre d'exemple, la couche de masquage 21 est retirée localement de sorte qu'elle ne subsiste qu'en vis à vis d'une partie centrale de l'empilement, et plus particulièrement en vis-à-vis d'une partie de l'empilement où sera formé le condensateur.

La couche de masquage 21 est par exemple en une résine photosensible.

La figure 3 illustre une structure obtenue à l'issue d'une étape de gravure d'une partie supérieure de la structure illustrée en figure 2. A titre d'exemple, la gravure correspond à une gravure plasma chimique, par exemple au moyen d'un plasma à base de chlore et/ou de fluor en utilisant la couche de masquage 21 comme masque de gravure.

A titre d'exemple, lors de cette étape, la couche conductrice 19, l'électrode 17 et une partie de l'épaisseur de la couche diélectrique 15 sont retirées dans une partie périphérique de l'empilement, c'est-à-dire hors du vis-à-vis de la couche de masquage 21. En d'autres termes, lors de cette étape, on vient retirer entièrement les portions de la couche conductrice 19 et de l'électrode 17 non recouvertes par la couche de masquage 21 et seulement une partie de l'épaisseur de la couche diélectrique 15 dans sa portion non recouverte par la couche de masquage 21. Encore en d'autres termes, on vient, lors de cette étape, créer des marches, débouchant dans la couche diélectrique 15, en dehors du vis-à-vis de la couche de masquage 21.

A titre d'exemple, à l'issue de cette étape, environ 50% de l'épaisseur de la couche diélectrique 15 subsiste en dehors du vis-à-vis de la couche de masquage 21. A titre d'exemple, à l'issue de cette étape, environ 20 nm de la couche diélectrique 15 subsiste en dehors du vis-à-vis de la couche de masquage 21.

A titre d'exemple, la couche de masquage 21 est retirée à l'issue de l'étape de gravure de la couche semiconductrice 19, de l'électrode 17 et de la couche diélectrique 15.

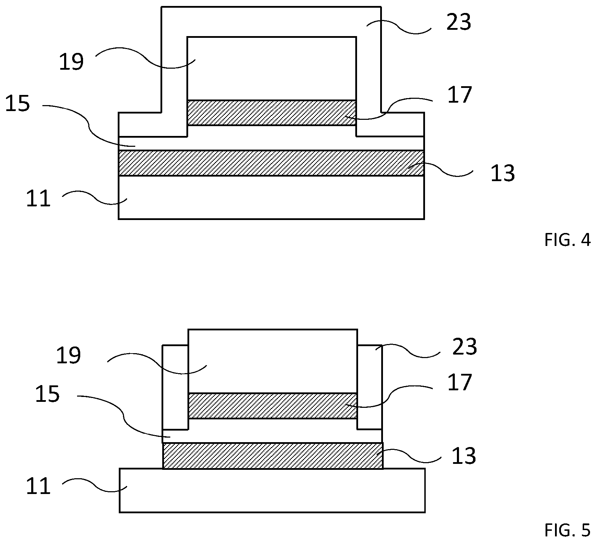

La figure 4 illustre une structure obtenue à l'issue d'une étape de dépôt d'une deuxième couche diélectrique 23 sur la face supérieure de la structure illustrée en figure 3.

Lors de cette étape, la couche 23 est plus précisément déposée sur la face supérieure de la couche 19, sur les flancs de la couche 19, sur les flancs de l'électrode 17, sur la partie de la face supérieure de la couche 15 non recouverte par la couche 17 et sur les flancs de la couche 15.

A titre d'exemple, la couche 23 est déposée de façon conforme, c'est-à-dire qu'elle est déposée sur toute la face supérieure de la structure avec une épaisseur uniforme. A titre d'exemple, l'épaisseur de la couche 23 est comprise entre 20 nm et 200 nm, par exemple de l'ordre de 100 nm. Les couches diélectriques 15 et 23 sont, par exemple, en le même matériau. A titre de variante, les couches diélectriques 15 et 23 sont en des matériaux différents. La couche 23 est en un matériau diélectrique, par exemple en un nitrure ou en un oxyde. A titre d'exemple, la couche 23 est en orthosilicate de tétraéthyle ou TEOS (de l'anglais " TetraEthylOrthoSilicate"), en nitrure de silicium ou en oxynitrure de tantale.

A titre d'exemple, les couches diélectriques 15 et 23 sont en le même matériau et sont formées avec la même épaisseur.

La figure 5 illustre une structure obtenue à l'issue d'une étape de gravure de la structure illustrée en figure 4.

Lors de cette étape, la structure illustrée en figure 4 est gravée, à partir de sa face supérieure, pleine plaque, c'est-à-dire sur toute sa surface.

La gravure de cette étape correspond à une gravure plasma chimique anisotrope verticale. En d'autres termes, la gravure est directive, elle s'effectue principalement dans une unique direction préférentielle, ici la direction verticale dans l'orientation de la figure.

A titre d'exemple, la gravure est effectuée au moyen d'un plasma à base de fluor. A titre d'exemple, cette étape de gravure est sélective et permet de retirer une partie de la couche diélectrique 23, une partie de l'électrode 13, une partie de la couche diélectrique 15 mais elle n'a pas ou peu d'action sur la couche conductrice 19 qui subsiste.

L'étape de gravure est, par exemple, arrêtée lorsque la face supérieure de la couche conductrice 11 est dévoilée dans la partie périphérique de l'empilement. Les couches 23 et 15 et l'électrode 13 se voient donc retirées successivement.

Ainsi, lors de cette étape, la couche diélectrique 23 se voit donc retirée dans la partie centrale de l'empilement, c'est-à-dire en vis à vis de la couche conductrice 19. Toujours lors de cette étape, l'électrode 13 et les couches diélectriques 15 et 23 se voient retirées dans la partie périphérique de l'empilement. Encore lors de cette étape, entre la partie centrale et la partie périphérique, une partie de la couche diélectrique 23 située sur les flancs de la couche conductrice 19 se voit retirée.

A l'issue de l'étape de gravure, la face supérieure de la couche conductrice 19 et la face supérieure de la couche diélectrique 23 ne sont pas alignées, la face supérieure de la couche 23 étant en retrait par rapport à la face supérieure de la couche 19. Ce décalage s'explique par le fait qu'il y a plus de matière qui peut être retirée, par la gravure plasma, dans la partie périphérique de l'empilement que dans la partie centrale de l'empilement. En effet, lorsque la couche diélectrique 23 a été retirée sur une épaisseur correspondant à l'épaisseur située dans la partie centrale de l'empilement, la gravure continue, la couche diélectrique 23 formée sur les flancs de la couche conductrice 19 est alors retirée. A titre d'exemple, à l'issue de cette étape, la différence de niveau entre la face supérieure de la couche 19 et la face supérieure de la couche 23 est de l'ordre de 40 nm.

A l'issue de l'étape de gravure, la structure comprend une partie centrale comportant successivement, sur la face supérieure de la couche conductrice 11, l'électrode 13, la couche diélectrique 15, l'électrode 17 et la couche conductrice 19. Dans cette structure, l'électrode 13 et une partie de la couche 15 se prolongent au delà des flancs de la couche 19 et sont surmontées par la couche 23 formée sur une partie des flancs des couches 19 et 15 et de l'électrode 17, de sorte que les flancs de l'électrode 13 et de la couche 15 soient alignés avec les flancs de la couche 23.

On notera que selon les matériaux utilisés, la vitesse de gravure de l'électrode 13 peut être légèrement supérieure à celle des couches 15 et 23. Dans ce cas, l'étape de gravure peut créer un léger retrait (non représenté) du flanc de l'électrode 13 par rapport au flanc des couches 15 et 23.

A l'issue de cette étape, un plot métallique, non représenté, par exemple en cuivre, est par exemple disposé sur la face supérieure de la couche conductrice 19.

Un avantage du présent mode de réalisation est qu'il permet de former un condensateur à un coût limité dans la mesure où le procédé comprend une unique étape de photolithographie.

Un autre avantage du présent mode de réalisation est qu'il permet de réduire l'écart entre le flanc de la couche conductrice 19 et le flanc de l'électrode 13, du fait de la protection conférée par la couche diélectrique 23 sur les flancs des couches 15 et 19.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation ne se limitent pas aux exemples de valeurs numériques ni aux exemples de matériaux mentionnés dans la présente description.

Enfin, la mise en oeuvre pratique des modes de réalisation et variantes décrits est à la portée de la personne du métier à partir des indications fonctionnelles données ci-dessus.

## Revendications

1. Procédé de fabrication d'un condensateur, comportant les étapes successives suivantes :
a) former un empilement comportant une face inférieure et une face supérieure, l'empilement comportant, dans l'ordre à partir de sa face inférieure, une première couche conductrice (11), une première électrode (13), une première couche diélectrique (15), une deuxième électrode (17) et une deuxième couche conductrice (19) ;
b) graver, par gravure localisée, à partir de la face supérieure de l'empilement, la deuxième couche conductrice (19), la deuxième électrode (17) et une partie de l'épaisseur de la première couche diélectrique (15) dans une partie périphérique de l'empilement ;
c) déposer une deuxième couche diélectrique (23), de façon conforme, sur toute la surface supérieure et les flancs d'une partie centrale, non gravée à l'étape b), de l'empilement, et sur la partie périphérique de l'empilement ; et
d) graver la deuxième couche diélectrique (23), la première couche diélectrique (15) et la première électrode (13), par gravure anisotrope verticale non localisée, jusqu'à exposer la face supérieure de la deuxième couche conductrice (19) dans ladite partie centrale, non gravée à l'étape b), de l'empilement et la face supérieure de la première couche conductrice (11) dans la partie périphérique de l'empilement, et en laissant subsister une portion de la deuxième couche diélectrique (23) sur les flancs de ladite partie centrale de l'empilement.

2. Procédé selon la revendication 1, dans lequel la gravure à l'étape b) est une gravure par plasma chimique.

3. Procédé selon la revendication 2, dans lequel le plasma de la gravure à l'étape b) est à base de chlore.

4. Procédé selon l'une quelconque des revendications 1 à 3, dans lequel la gravure de l'étape d) est effectuée pleine plaque.

5. Procédé selon l'une quelconque des revendications 1 à 4, dans lequel la gravure à l'étape d) est une gravure par plasma chimique.

6. Procédé selon la revendication 5, dans lequel le plasma de la gravure à l'étape b) est à base de fluor.

7. Procédé selon l'une quelconque des revendications 1 à 6, comportant, entre les étapes a) et b), une étape de formation d'un masque de gravure (21).

8. Procédé selon l'une quelconque des revendications 1 à 7, dans lequel les première (11) et deuxième (19) couches conductrices sont à base d'aluminium.

9. Procédé selon l'une quelconque des revendications 1 à 8, dans lequel les première (15) et deuxième (23) couches diélectriques, sont en le même matériau.

10. Procédé selon l'une quelconque des revendications 1 à 9, dans lequel les première (15) et deuxième (23) couches diélectriques sont en nitrure de silicium.

11. Procédé selon l'une quelconque des revendications 1 à 10, dans lequel les première (13) et deuxième (17) électrodes sont en nitrure de tantale.

12. Condensateur comportant une première couche conductrice (11) sur laquelle est formé un empilement, comportant, à partir de la face supérieure de la première couche (11), une première électrode (13), une première couche diélectrique (15), une deuxième électrode (17) et une deuxième couche conductrice (19), l'empilement comportant une marche, dans la deuxième couche conductrice (19), la deuxième électrode (17) et dans une partie de l'épaisseur de la première couche diélectrique (15), la marche étant comblée par une deuxième couche diélectrique (23) de sorte que les flancs de la première électrode (13) soient alignés avec les flancs de la deuxième couche diélectrique (23), la première couche conductrice (11) n'étant pas recouverte par la deuxième couche diélectrique (23) autour de l'empilement.

## Patentansprüche

1. Ein Verfahren zur Herstellung eines Kondensators, das die folgenden aufeinanderfolgenden Schritte aufweist:
a) Ausbilden eines Stapels, der eine Unterseite und eine Oberseite aufweist, wobei der Stapel in der Reihenfolge von seiner Unterseite aus eine erste leitfähige Schicht (11), eine erste Elektrode (13), eine erste dielektrische Schicht (15), eine zweite Elektrode (17) und eine zweite leitfähige Schicht (19) aufweist;
b) Wegätzen durch lokalisiertes Ätzen von der Oberseite des Stapels der zweiten leitfähigen Schicht (19), der zweiten Elektrode (17) und eines Teils der Dicke der ersten dielektrischen Schicht (15) innerhalb eines peripheren Abschnitts des Stapels;
c) Ausbilden einer zweiten dielektrischen Schicht (23) in konformer Weise über der gesamten Oberseite und den Seiten eines mittleren Abschnitts des Stapels, der in Schritt b) nicht geätzt wird, und über dem peripheren Abschnitt des Stapels; und
d) Wegätzen der zweiten dielektrischen Schicht (23), der ersten dielektrischen Schicht (15) und der ersten Elektrode (13) durch nicht lokalisiertes vertikales anisotropes Ätzen, bis die Oberseite der zweiten leitfähigen Schicht (19) in einem mittleren Abschnitt des Stapels, der in Schritt b) nicht geätzt wird, und die Oberseite der ersten leitfähigen Schicht (11) innerhalb des peripheren Abschnitts des Stapels freigelegt werden, wobei ein Abschnitt der zweiten dielektrischen Schicht (23) an den Seiten des genannten mittleren Abschnitts des Stapels verbleibt.

2. Das Verfahren nach Anspruch 1, wobei das Ätzen in Schritt b) ein chemisches Plasmaätzen ist.

3. Das Verfahren nach Anspruch 2, wobei das Plasma des Ätzens in Schritt b) ein chlorbasiertes Plasma ist.

4. Das Verfahren nach einem der Ansprüche 1 bis 3, wobei das Ätzen in Schritt d) auf dem gesamten Wafer durchgeführt wird.

5. Das Verfahren nach einem der Ansprüche 1 bis 4, wobei das Ätzen in Schritt d) ein chemisches Plasmaätzen ist.

6. Das Verfahren nach Anspruch 5, wobei das Plasma des Ätzens in Schritt b) ein fluorbasiertes Plasma ist.

7. Das Verfahren nach einem der Ansprüche 1 bis 6, aufweisend zwischen den Schritten a) und b) einen Schritt des Ausbildens einer Ätzmaske (21).

8. Das Verfahren nach einem der Ansprüche 1 bis 7, wobei die erste (11) und die zweite (19) leitfähige Schicht aluminiumbasierte Schichten sind.

9. Das Verfahren nach einem der Ansprüche 1 bis 8, wobei die erste (15) und die zweite (23) dielektrische Schicht aus demselben Material hergestellt sind.

10. Das Verfahren nach einem der Ansprüche 1 bis 9, wobei die erste (15) und die zweite (23) dielektrische Schicht aus Siliziumnitrid hergestellt sind.

11. Das Verfahren nach einem der Ansprüche 1 bis 10, wobei die erste (13) und die zweite (17) Elektrode aus Tantalnitrid hergestellt sind.

12. Ein Kondensator, der eine erste leitfähige Schicht (11) aufweist, über der ein Stapel ausgebildet ist, wobei der Stapel von der Oberseite der ersten Schicht (11) aus eine erste Elektrode (13), eine erste dielektrische Schicht (15), eine zweite Elektrode (17) und eine zweite leitfähige Schicht (19) aufweist, wobei der Stapel eine Stufe innerhalb der zweiten leitfähigen Schicht (19), der zweiten Elektrode (17) und in einem Teil der Dicke der ersten dielektrischen Schicht (15) aufweist, wobei die Stufe mit einer zweiten dielektrischen Schicht (23) gefüllt ist, sodass die Seitenwände der ersten Elektrode (13) in Bezug auf die Seitenwände der zweiten dielektrischen Schicht (23) ausgerichtet sind, wobei die erste leitfähige Schicht (11) um den Stapel herum nicht von der zweiten dielektrischen Schicht (23) bedeckt ist.

## Claims

1. A method of fabricating a capacitor, comprising the following successive steps:
a) forming a stack including a bottom face and an upper face, the stack comprising in the order from its bottom face, a first conductive layer (11), a first electrode (13), a first dielectric layer (15), a second electrode (17), and a second conductive layer (19);
b) etching away by localized etching, from the upper face of the stack, the second conductive layer (19), the second electrode (17), and a part of the thickness of the first dielectric layer (15) within a peripheral part of the stack;
c) forming a second dielectric layer (23), conformally, over the whole upper surface and sides of a middle part of the stack, being not etched in step b), and over the peripherical part of the stack ; and
d) etching away the second dielectric layer (23), the first dielectric layer (15), and the first electrode (13), by non-localized vertical anisotropic etching, until exposing the upper face of the second conductive layer (19) in a middle part, being not etched in step b), of the stack, and the upper face of the first conductive layer (11) within the peripheral part of the stack, while leaving a portion of the second dielectric layer (23) on the sides of said middle part of the stack.

2. The method according to claim 1, wherein the etching in step b) is a chemical plasma etching.

3. The method according to claim 2, wherein the plasma of the etching in step b) is a chlorine-based plasma.

4. The method according to any one of claims 1 to 3, wherein the etching in step d) is performed whole wafer.

5. The method according to any one of claims 1 to 4, wherein the etching in step d) is a chemical plasma etching.

6. The method according to claim 5, wherein the plasma of the etching in step b) is a fluorine-based plasma.

7. The method according to any one of claims 1 to 6, comprising between the steps a) and b), a step of forming an etching mask (21).

8. The method according to any one of claims 1 to 7, wherein the first (11) and second (19) conductive layers are aluminium-based layers.

9. The method according to any one of claims 1 to 8, wherein the first (15) and second (23) dielectric layers are made of the same material.

10. The method according to any one of claims 1 to 9, wherein the first (15) and second (23) dielectric layers are made of silicon nitride.

11. The method according to any one of claims 1 to 10, wherein the first (13) and second (17) electrodes are made of tantalum nitride.

12. A capacitor including a first conductive layer (11) over which is formed a stack, comprising from the upper face of the first layer (11), a first electrode (13), a first dielectric layer (15), a second electrode (17), and a second conductive layer (19), the stack comprising a stair step within the second conductive layer (19), the second electrode (17), and in a part of the thickness of the first dielectric layer (15), the stair step being filled with a second dielectric layer (23) so that the sidewalls of the first electrode (13) are aligned with respect to the sidewalls of the second dielectric layer (23), the first conductive layer (11) being not covered by the second dielectric layer (23) around the stack.
